# EUROPEAN PATENT SPECIFICATION

(11) **EP 3 379 280 B1**
(45) Date of publication and mention of the grant of the patent: **23.08.2023**
(21) Application number: 18162559.1
(22) Date of filing: 19.03.2018
(51) Int. Cl.: G01R 33/34

(54) **SPLITTABLE RF COIL**
TRENNBARE RF-SPULE
BOBINE RF DIVISIBLE

(30) Priority: 21.03.2017 CN 201720291118 U
(43) Date of publication of application: 26.09.2018
(73) Proprietor: Siemens Healthcare GmbH, 91052 Erlangen (DE)
(72) Inventor: You, Jun, Shenzhen, 518028 (CN)
(74) Representative: Bals & Vogel Patentanwälte PartGmbB

(56) References cited:
- JP-A- H06 254 068
- JP-B2- 3 128 263

## Description

### Technical field

The present invention relates to a local coil.

### Background art

At present, a local coil e.g. a knee coil comprises two parts, namely an upper coil and a lower coil; when a magnetic resonance scan is carried out, it is necessary for the upper coil and the lower coil to be connected to each other by means of an electrical connector, and locked by a locking apparatus. However, when a locking apparatus of an existing local coil is unlocked, two unlocking buttons disposed on two end sides of the upper coil are pressed towards a radially inner side, but after unlocking, the upper coil is moved in a direction perpendicular to the radial direction and thereby detached from the lower coil. Thus, from the operator's point of view, the force used to achieve unlocking is not in the same direction as the movement of removing the upper coil, therefore the operation is inconvenient for the operator, and this is not helpful with regard to increasing the operating efficiency when the upper and lower halves of the local coil are frequently disassembled. In addition, since metal connectors used for connecting to the lower coil and exposed on the outside of the upper coil are disposed at the position of contact between the upper coil and the lower coil, a separate protecting element must be additionally provided so that, once the upper coil has been removed, the metal connectors are not damaged when the upper coil is placed on its own.

A local coil for MRI comprising a first and a second coil half body and a locking apparatus is known from each of JP406254068A1 and JP3128263B2.

### Summary of the invention

In view of the above, the present invention proposes a local coil which uses a simple structure to increase the disassembly efficiency of the local coil and does not need an electrical connector protecting apparatus to be separately provided.

According to the invention, a local coil for a magnetic resonance scan is provided as defined in claim 1. The local coil comprises: a first coil half body; a second coil half body, provided with an electrical connector protruding towards the first coil half body, and being electrically connectable to the first coil half body by means of the electrical connector, the second coil half body being separable from the first coil half body together with the electrical connector in a first direction; a locking apparatus, comprising an engagement plate shaft-supported on the second coil half body, one end of the engagement plate being engagable with the first coil half body in a locking position, and one end of the engagement plate being turnable in the same direction as the first direction so as to move to an unlocking position in which the engagement is released.

According to the invention, the locking apparatus comprises a return spring, the return spring being set so as to always apply a force to the engagement plate towards the locking position, and in a state in which the first coil half body and the second coil half body have been separated, the engagement plate remains in the locking position, and projects further than the electrical connector in the direction of protrusion. In addition, in the local coil described above, preferably, a peripheral surface of the engagement plate is set so as to remain as the same peripheral surface as a peripheral surface of the second coil half body. The technical solution according to the present invention can use a simple structure to realize a local coil which has an increased local coil disassembly efficiency and does not need an electrical connector protecting apparatus to be separately provided.

### Description of the accompanying drawings

Preferred embodiments of the present invention are described in detail below with reference to the accompanying drawings, to give those skilled in the art a clearer understanding of the abovementioned and other features and advantages of the present invention.

### Drawings:

Fig. 1 shows an exploded three-dimensional drawing of an upper coil to which an embodiment of the present invention relates.
Fig. 2 shows a sectional view of a locking apparatus of the
present invention.
Fig. 3 is a drawing showing the state of the upper coil and a lower coil after being connected together.
Fig. 4 is an illustrative drawing showing the unlocking of the upper coil.
Fig. 5 shows a main view of the upper coil to which the locking apparatus has been fitted, after being removed from the lower coil.

### Key to the drawings:

1 locking apparatus;
2 coil body;
10 engagement plate;
11 hook part;
20 support;
30 shaft;
40 return spring;
50 upper coil;
60 lower coil;
61 protruding edge

### Particular embodiments

In order to clarify the object, technical solution and advantages of the present invention, the present invention is explained in further detail below by way of embodiments.

As used herein, "schematic" means "serving as an instance, example or illustration". No drawing or embodiment described herein as "schematic" should be interpreted as a more preferred or more advantageous technical solution.

To make the drawings appear uncluttered, only those parts relevant to the present invention are shown schematically in the drawings; they do not represent the actual structure thereof as a product. Furthermore, to make the drawings appear uncluttered for ease of understanding, in the case of components having the same structure or function in certain drawings, only one of these is drawn schematically, or only one is marked.

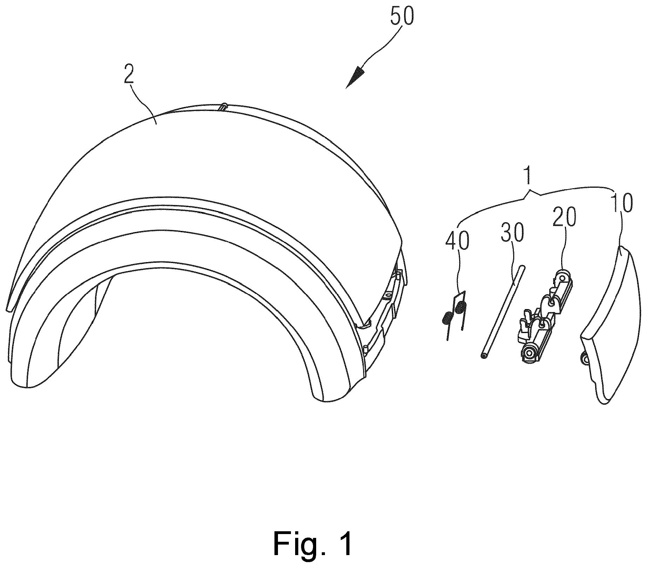

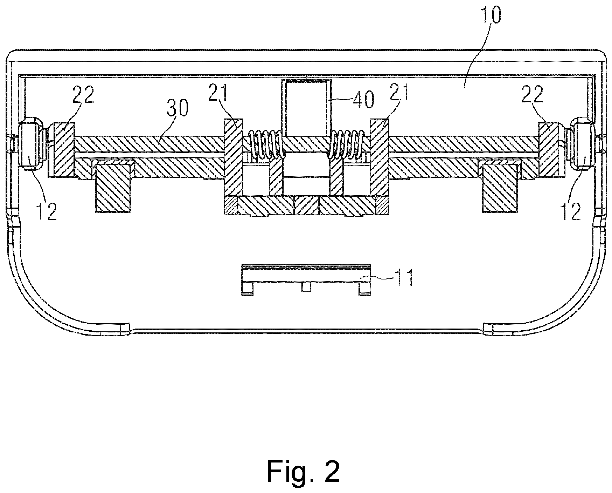

Preferred embodiments of the present invention are explained below with reference to the accompanying drawings. In this embodiment, an explanation is given taking a knee coil as an example. Fig. 1 shows an exploded three-dimensional drawing of an upper coil 50 to which an embodiment of the present invention relates. Fig. 2 shows a sectional view of a locking apparatus 1 of the present invention.

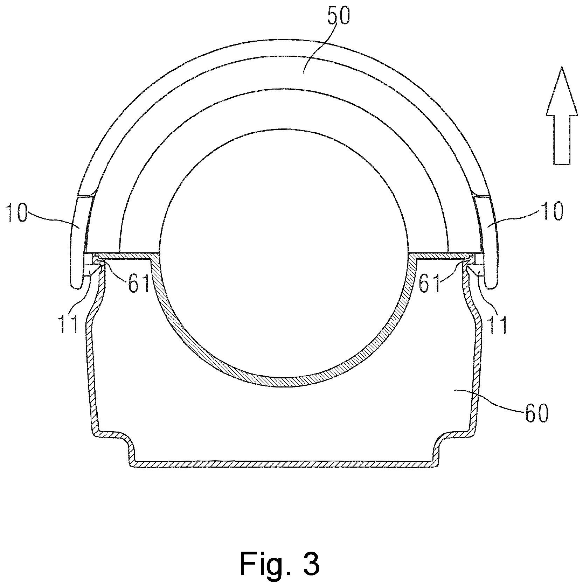

As shown in figs. 1 and 2, the upper coil 50 (second coil half body) comprises a locking apparatus 1 and a coil body 2. The locking apparatus 1 comprises an engagement plate 10, a support 20, a shaft 30 and a return spring 40. The engagement plate 10 is a substantially plate-like component, disposed on the coil body 2. In the state of being disposed on the coil body 2, a hook part 11 for engaging with a lower coil 60 (first coil half body) described later is disposed on an end side (in a circumferential direction of the upper coil 50) of the engagement plate; in addition, support parts 12 for supporting the shaft 30 described later are disposed at two ends (in an axial direction of the upper coil 50) of the engagement plate 10 (see fig. 3). The cradle 20 has support seats 21 disposed in a substantially central part and used for locating the return spring 40, and shaft holes 22 disposed at two ends and used for supporting the shaft 30. The return spring 40 is a coil spring; when assembly is carried out, first of all the return spring 40 is located between the two support seats 21 of the cradle 20, and the shaft 30 is passed through the shaft holes 22, the support seats 21 and the return spring 40, and the cradle 20 is fixed to the coil body using screws etc., thereby fitting the locking apparatus 1 to the upper coil 50.

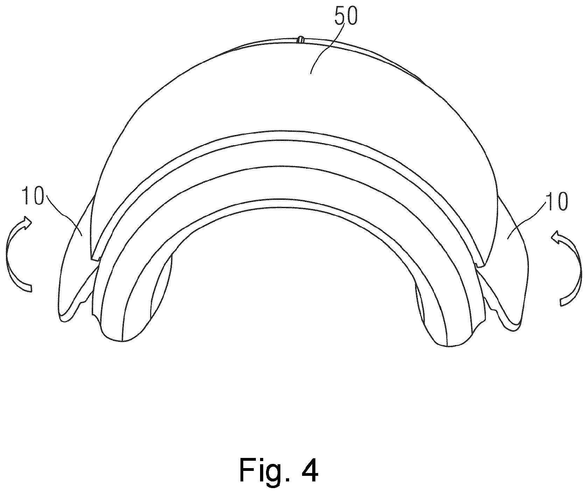

Fig. 3 shows a drawing of the state of the upper coil 50 and lower coil 60 after being connected together. Fig. 4 shows a three-dimensional drawing of the upper coil 50 being unlocked.

As shown in fig. 3, when a local coil is used for scanning, a connector 51 of the upper coil 50 is inserted into an insertion hole (not shown) of the lower coil 60, thereby realizing the electrical connection of the upper coil 50 to the lower coil 60. At the same time, the engagement plate 10 of the locking apparatus 1 rotates around the shaft 30 under the action of the return spring 40, thereby causing the hook part 11 to automatically engage with a protruding edge 61 of the lower coil 60, and thereby locking the upper coil 50 to the lower coil 60. When the scan has ended, as shown in fig. 4, the engagement plates 10 are pulled up in the direction of the arrows in fig. 4. At this time, a lower end of the engagement plate 10 is turned around the shaft 30 thereof, such that the hook part 11 of the engagement plate 10 is separated from the protruding edge 61 of the lower coil 60, and the upper coil 50 can then be separated from the lower coil 60 in an upward direction (in the direction of the arrow shown in fig. 3). According to the invention, the direction in which force is applied to the locking apparatus 1 of the upper coil 50 during unlocking (the direction of the arrows in fig. 4) is the same as the direction of separation of the upper coil 50 after unlocking (the direction of the arrow in fig. 3), so it is possible to complete the operation of removing the upper coil at the same time as unlocking is performed, thereby increasing the operating efficiency of the coil.

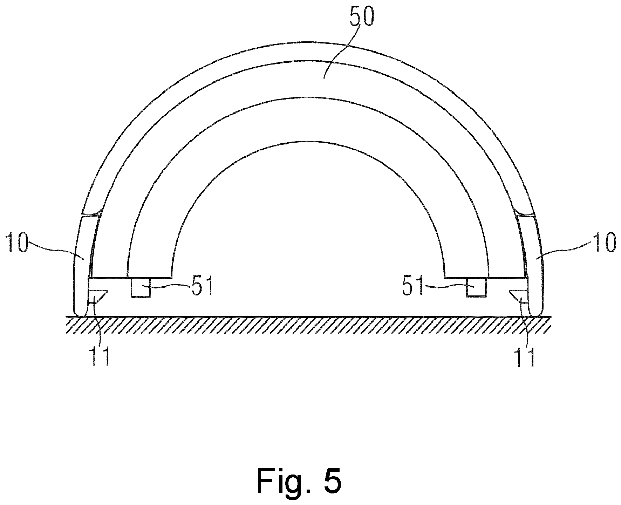

Fig. 5 shows a main view of the upper coil 50 to which the locking apparatus 1 has been fitted, after being removed from the lower coil 60 (see fig. 3).

As shown in fig. 5, the engagement plate 10 of the locking apparatus 1 is set so that a peripheral surface thereof and a peripheral surface of the upper coil 50 are the same peripheral surface. When the upper coil 50 has been removed from the lower coil 60 (see fig. 3), the engagement plates 10 of the locking apparatus 1 remain in a locking position under the action of the return spring 40; compared with the connectors 51 of the upper coil 50 protruding to the outside of the coil, the engagement plates 10 project further in the direction of protrusion. Thus, when the upper coil 50 is removed from the lower coil 60 and placed on a table, the engagement plates 10 remain in a locking position under the action of the return spring 40, and since the engagement plates 10 project further than the connectors 51 in the direction of protrusion thereof (the lower side of fig. 5), the engagement plates 10 are in contact with a surface of a supporting object such as a table, so there is no longer any need to provide additional protecting components, as in the past, to protect the connectors 51, and direct contact between the connectors 51 and the surface of the supporting object, resulting in damage to the connectors 51, can be avoided.

In the embodiments above, once the upper coil 50 and the lower coil 60 have been separated, the return spring 40 is used to keep the engagement plate 10 in a locking position, but this is not a limitation; it is only necessary to enable the engagement plates 10 to project in the direction of protrusion of the connectors 51, by a distance greater that the protruding length of the connectors 51, e.g. a limiting component determining the position of the engagement plate 10 after unlocking may be provided.

In addition, a knee coil has been shown by way of example in the embodiments above, with the upper coil 50 thereof separating the coil body and connectors from the lower coil 60 in an upward direction, but the present invention is not limited to a knee coil, and could also be a spine coil, etc. When used for a spine coil, one coil half body is separated from another coil half body in a horizontal direction parallel to a patient table, in which case the direction of unlocking of the engagement plate is also a horizontal direction.

The embodiments above are merely preferred embodiments of the present invention, which are not intended to limit it. In any case, the scope of the invention is defined by the claims.

## Claims

1. A local coil for a magnetic resonance scan, comprising: a first coil half body;
a second coil half body, provided with an electrical connector protruding towards the first coil half body, and being electrically connectable to the first coil half body by means of the electrical connector, the second coil half body being separable from the first coil half body together with the electrical connector in a first direction;
a locking apparatus, comprising an engagement plate shaft-supported on the second coil half body, one end of the engagement plate being engagable with the first coil half body in a locking position, and one end of the engagement plate being turnable in the same direction as the first direction so as to move to an unlocking position in which the engagement is released,
**characterized in that**
the locking apparatus comprises a return spring, the return spring being set so as to always apply a force to the engagement plate towards the locking position, and in a state in which the first coil half body and the second coil half body have been separated, the engagement plate remains in the locking position, and projects further than the electrical connector in the direction of protrusion.

2. The local coil as claimed in claim 1, **characterized in that** a peripheral surface of the engagement plate is set so as to remain as the same peripheral surface as a peripheral surface of the second coil half body.

## Patentansprüche

1. Lokale Spule für eine Magnetresonanzabtastung,
umfassend: einen ersten Spulenhalbkörper;
einen zweiten Spulenhalbkörper, der mit einem elektrischen Verbinder versehen ist, der in Richtung des ersten Spulenhalbkörpers vorsteht, und der mittels des elektrischen Verbinders mit dem ersten Spulenhalbkörper elektrisch verbindbar ist, wobei der zweite Spulenhalbkörper zusammen mit dem elektrischen Verbinder in einer ersten Richtung von dem ersten Spulenhalbkörper trennbar ist;
eine Verriegelungsvorrichtung, die eine auf dem zweiten Spulenhalbkörper wellengelagerte Eingriffsplatte umfasst, wobei ein Ende der Eingriffsplatte in einer Verriegelungsposition mit dem ersten Spulenhalbkörper in Eingriff gebracht werden kann und ein Ende der Eingriffsplatte in der gleichen Richtung wie die erste Richtung gedreht werden kann, um sich in eine Entriegelungsposition zu bewegen, in der der Eingriff gelöst ist,
**dadurch gekennzeichnet, dass**
die Verriegelungsvorrichtung eine Rückstellfeder umfasst, wobei die Rückstellfeder so eingestellt ist, dass sie immer eine Kraft auf die Eingriffsplatte in Richtung der Verriegelungsposition ausübt, und in einem Zustand, in dem der erste Spulenhalbkörper und der zweite Spulenhalbkörper getrennt worden sind, die Eingriffsplatte in der Verriegelungsposition verbleibt und weiter als der elektrische Verbinder in der Richtung des Vorsprungs vorsteht.

2. Lokale Spule nach Anspruch 1, **dadurch gekennzeichnet, dass**
eine Umfangsfläche der Eingriffsplatte so eingestellt ist, dass sie als dieselbe Umfangsfläche wie eine Umfangsfläche des zweiten Spulenhalbkörpers bleibt.

## Revendications

1. Bobine locale pour un scanner à résonance magnétique,
comprenant : un premier demi-corps de bobine ;
un deuxième demi-corps de bobine, muni d'un connecteur électrique faisant saillie vers le premier demi-corps de bobine, et pouvant être connecté électriquement au premier demi-corps de bobine au moyen du connecteur électrique, le deuxième demi-corps de bobine pouvant être séparé du premier demi-corps de bobine avec le connecteur électrique dans une première direction ;
un appareil de verrouillage, comprenant une plaque d'engagement supportée par l'arbre sur le deuxième demi-corps de bobine, une extrémité de la plaque d'engagement pouvant être engagée avec le premier demi-corps de bobine dans une position de verrouillage, et une extrémité de la plaque d'engagement pouvant être tournée dans la même direction que la première direction de manière à se déplacer vers une position de déverrouillage dans laquelle l'engagement est relâché,
**caractérisé en ce que**
l' appareil de verrouillage comprend un ressort de rappel, le ressort de rappel étant réglé de manière à toujours appliquer une force à la plaque d'engagement vers la position de verrouillage, et dans un état dans lequel le premier demi-corps de bobine et le second demi-corps de bobine ont été séparés, la plaque d'engagement reste dans la position de verrouillage, et dépasse le connecteur électrique dans la direction de la saillie.

2. Bobine locale selon la revendication 1, **caractérisée en ce que**
une surface périphérique de la plaque d'engagement est réglée de manière à rester la même surface périphérique qu'une surface périphérique du deuxième demi-corps de bobine.
